# EUROPEAN PATENT APPLICATION

(11) **EP 4 411 435 A1**
(43) Date of publication of application: **07.08.2024**
(21) Application number: 24150792.0
(22) Date of filing: 08.01.2024
(51) Int. Cl.: G02B 5/22, G02F 1/13, C09D 7/41, G02F 1/1335

(54) **DISPLAY DEVICE**

(30) Priority: 31.01.2023 KR 20230012904
(71) Applicant: LG Display Co., Ltd., Seoul 07336 (KR)
(72) Inventor: Cho, Wonjong, 10845 Paju-si (KR); Noh, HyunJong, 10845 Paju-si (KR)
(74) Representative: Cousens, Nico

(57) **Abstract**

Provided is a display device. The display device comprises a display panel in which a 1-1-th reflectance at a wavelength of 650 nm to 680 nm is larger than a 1-2-th reflectance at a wavelength of 420 nm to 440 nm; a first layer which is disposed on the display panel and has a first transmittance in a first wavelength range, a second transmittance in a second wavelength range different from the first wavelength range, and a third transmittance in a third wavelength range different from the first wavelength range and the second wavelength range; a barrier film disposed on the first layer; and a second layer disposed on the barrier film.

## Description

### CROSS-REFERENCE TO RELATED APPLICATIONS

This application claims the priority of Korean Patent Application No. 10-2023-0012904 filed on January 31, 2023, in the Korean Intellectual Property Office.

### BACKGROUND

### Technical Field

The present disclosure relates to a display device, and more particularly, to a display device which implements a low reflectance and a reddish neutral black by means of an optimal structure design, without including a polarization film.

### Description of the Related Art

The display device may be an organic light emitting display device. Unlike a liquid crystal display device (LCD) which includes a backlight, an organic light emitting display device (OLED) does not include a separate light source. Therefore, the organic light emitting display device can be manufactured to be light and thin and has process advantages and has a low power consumption due to the low voltage driving. First of all, the organic light emitting display device includes a self-emitting element and includes layers formed of organic thin films so that the flexibility and elasticity are improved compared to the other display devices and thus it is advantageous to be implemented as a display panel.

Generally, a display panel of the display device includes a polarization film to minimize or reduce reflection by external light. However, the price of polarization film is excessive due to the recent price increase, so that there is an increasing need for a display device which has a low reflectance, can increase light efficiency, and can implement a reddish neutral black, without a polarization film. A neutral black refers to a color of a display device in a power-off state.

### BRIEF SUMMARY

A benefit to be achieved by the present disclosure is to provide a display device with a low reflectance without having a polarization film.

Another benefit to be achieved by the present disclosure is to provide a display device which implements a neutral black at a low cost.

Benefits of the present disclosure are not limited to the above-mentioned benefits, and other benefits, which are not mentioned above, can be clearly understood by those skilled in the art from the following descriptions.

According to an aspect of the present disclosure, a display device includes a display panel in which a 1-1-th reflectance at a wavelength in a range of 650 nanometers (nm) to 680 nm is larger than a 1-2-th reflectance at a wavelength in a range of 420 nm to 440 nm; a first layer which is disposed on the display panel and has a first transmittance in a first wavelength range, a second transmittance in a second wavelength range different from the first wavelength range, and a third transmittance in a third wavelength range different from the first wavelength range and the second wavelength range; a barrier film disposed on the first layer; and a second layer disposed on the barrier film.

Other detailed matters of the exemplary embodiments are included in the detailed description and the drawings.

According to the present disclosure, a display device with a low reflectance without having a polarization film may be provided.

According to the present disclosure, a display device which implements a neutral black at a low cost may be provided.

The effects according to the present disclosure are not limited to the contents exemplified above, and more various effects are included in the present specification.

### BRIEF DESCRIPTION OF THE SEVERAL VIEWS OF THE DRAWINGS

The above and other aspects, features and other advantages of the present disclosure will be more clearly understood from the following detailed description taken in conjunction with the accompanying drawings, in which:
FIG. 1 is a plan view of a display device according to an exemplary embodiment of the present specification;
FIG. 2 is a perspective view illustrating a state in which a display device of FIG. 1 is folded;
FIG. 3 is a cross-sectional view schematically illustrating an example of a cross section of a pixel included in a display device of FIGS. 1 and 2;
FIG. 4 is a schematic cross-sectional view illustrating an example of a display device including a reflective visibility adjusting film disposed on a display panel of FIG. 1;
FIG. 5 is a schematic cross-sectional view illustrating another example of a display device including a reflective visibility adjusting film disposed on a display panel of FIG. 1;
FIG. 6 is a graph obtained by measuring transmittance for every wavelength according to Cases 1 to 3 of a first layer which configures a reflective visibility adjusting film used for a display device according to an exemplary embodiment of the present disclosure;
FIG. 7 is a table illustrating an optical characteristic of a reflective visibility adjusting film including a first layer of the above-described Cases 1 to 3;
FIG. 8 is a table illustrating an optical characteristic of Case 3 according to a reflectance of a second layer; and
FIG. 9 is a table illustrating an optical characteristic of Comparative Embodiments 5 to 7 which are additional Comparative Embodiments and a Comparative Embodiment of a HTO structure.

### DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on," "above," "below," and "next," one or more parts may be positioned between the two parts unless the terms are used with the term "immediately" or "directly."

When an element or layer is disposed "on" another element or layer, another layer or another element may be interposed directly on the other element or therebetween.

Although the terms "first," "second," and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to exemplary embodiments of the present disclosure will be described in detail with reference to accompanying drawings.

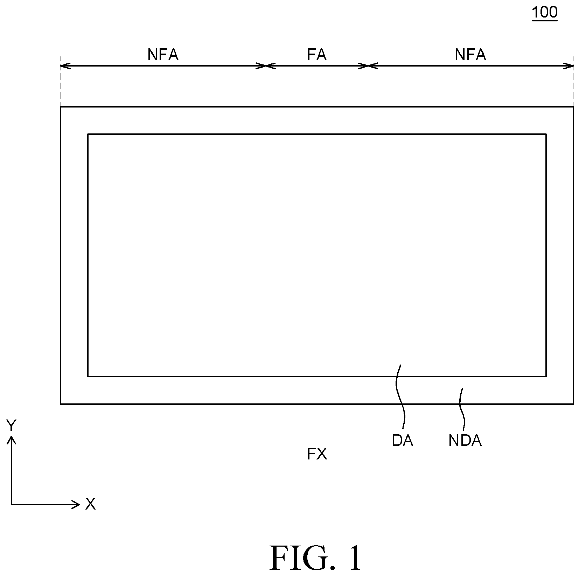

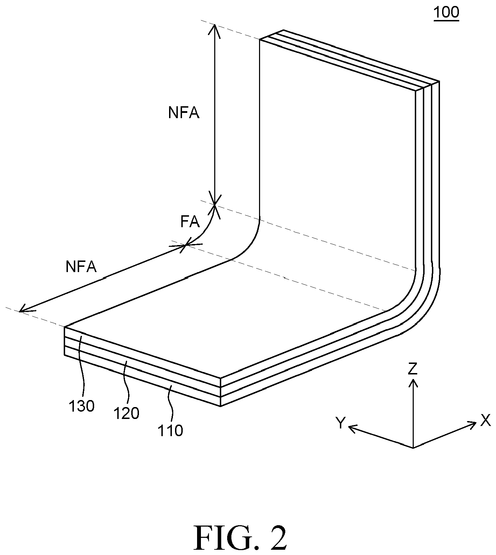

FIG. 1 is a plan view of a display device according to an exemplary embodiment of the present specification. FIG. 2 is a perspective view illustrating a state in which a display device of FIG. 1 is folded.

A display device 100 according to an exemplary embodiment of the present specification includes a display panel 110, an optical member 120, and a window member 130. Hereinafter, for the convenience of description, the display device 100 according to the exemplary embodiment of the present specification is assumed as an organic light emitting display device, but it is not limited thereto.

Referring to FIG. 1, the display device 100 according to the exemplary embodiment of the present specification includes a display area DA and a non-display area NDA. The display area DA is an area where a plurality of pixels is disposed to substantially display images. In the display area DA, a plurality of pixels which includes an emission area to display images, a thin film transistor for driving the pixels, a capacitor, and the like may be disposed. One pixel may include a plurality of sub pixels SP. The sub pixel SP is a minimum unit which configures the display area and each sub pixel SP may be configured to emit light of a specific wavelength band. For example, each of the sub pixels SP may be configured to emit red light, green light, blue light, or white light. The non-display area NDA is disposed so as to enclose the display area DA. The non-display area NDA is an area where images are not substantially displayed and various wiring lines and driving ICs for driving the pixels and the driving elements disposed in the display area DA are disposed therein. For example, in the non-display area NDA, various driving ICs such as a gate driver IC and a data driver IC, VSS lines, and the like may be disposed.

Referring to FIGS. 1 and 2, the display device 100 according to the exemplary embodiment of the present specification includes a folding area FA and a non-folding area NFA. The folding area FA is an area which is folded when the display device 100 is folded and may be folded along a specific radius of curvature with respect to a folding axis FX. For example, a folding axis FX of the folding area FA may be formed in a Y-axis direction and the non-folding area NFA may extend from the folding area FA in an X-axis direction which is perpendicular to the folding axis FX.

When the display device 100 is folded, if the folding area FA is folded with respect to the folding axis FX, the folding area FA may form a part of a circle or an oval. A radius of curvature of the folding area FA may be a radius of a circle or an oval formed by the folding area FA. When a top surface of the display device 100 on which images are displayed is referred to as a display surface and a bottom surface of the display device 100 which is an opposite surface of the display surface is referred to as a rear surface, the folding area FA may be folded by a method selected from an out-folding method and an in-folding method. According to the out-folding method, the folding area is folded to expose the display surface of the display device 100 to the outside and according to the in-folding method, the folding area is folded such that the display surfaces of the display device 100 face each other.

The non-folding area NFA is an area which is not folded when the display device 100 is folded. For example, the non-folding area NFA maintains a flat state when the display device 100 is folded. The non-folding area NFA may be located on both sides of the folding area FA. For example, the non-folding area NFA may be an area extending to the X-axis direction with respect to the folding axis FX. The folding area FA may be positioned between the non-folding areas NFA. Further, when the display device 100 is folded with respect to the folding axis FX, the non-folding areas NFA may overlap each other.

In FIGS. 1 and 2, even though it is illustrated that in the display device 100, one folding area FA and two non-folding areas NFA are disposed, the number and the position of folding areas FA and non-folding areas NFA may vary in various forms, but they are not limited thereto. For example, the display device 100 may include two or more folding areas FA and/or three or more non-folding areas.

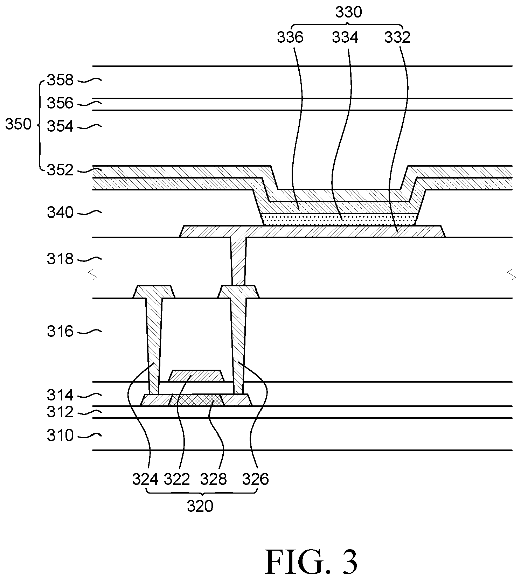

FIG. 3 is a cross-sectional view schematically illustrating an example of a cross section of a pixel included in a display device of FIGS. 1 and 2.

Referring to FIG. 3, a substrate 310 serves to support and protect components of the display device 100 disposed above the substrate 310. The substrate 310 may be formed of a flexible material having flexibility, so that the substrate 310 may be a flexible substrate. For example, the flexible substrate may be a film type substrate including one of a group consisting of a polyester-based polymer, a silicon-based polymer, an acrylic polymer, a polyolefin-based polymer, and a copolymer thereof.

For example, the flexible substrate may be formed of or include at least one of polyethylene terephthalate (PET), polybutylene terephthalate (PBT), polysilane, polysiloxane, polysilazane, polycarbosilane, polyacrylate, polymethacrylate, polymethylacrylate, polymethylmetacrylate, polyethylacrylate, polyethylmetacrylate, cycloolefin copolymer (COC), cycloolefin polymer (COP), polyethylene (PE), polypropylene (PP), polyimide (PI), polymethylmethacrylate (PMMA), polystyrene (PS), polyacetal (POM), polyether ether ketone (PEEK), polyester sulfone (PES), polytetrafluoroethylene (PTFE), polyvinyl chloride (PVC), polycarbonate (PC), polyvinylidene fluoride (PVDF), perfluoroalkyl polymer (PFA), styrene acrylic nitrile copolymer (SAN), and a combination thereof.

A buffer layer 312 is disposed on the flexible substrate 310. The buffer layer 312 configured by a single layer or a plurality of layers of silicon oxide SiOx or silicon nitride SiNx suppresses the permeation of moisture or other impurities through the substrate 310 to planarize a surface of the substrate 310. The buffer layer 312 is an optional component and may be omitted depending on a type of the substrate 310 or a type of a thin film transistor disposed on the substrate 310.

The thin film transistor 320 disposed on the buffer layer 312 includes a gate electrode 322, a source electrode 324, a drain electrode 326, and a semiconductor layer 328.

The semiconductor layer 328 may be configured by amorphous silicon or polycrystalline silicon, but is not limited thereto. The polycrystalline silicon has a better mobility than amorphous silicon and has low power consumption and excellent reliability so as to be applied to the driving thin film transistor in the pixel.

Recently, an oxide semiconductor has been spotlighted for its excellent mobility and uniformity. The oxide semiconductor may be configured by an indium tin gallium zinc oxide (InSnGaZnO)-based material which is a quaternary metallic oxide, an indium gallium zinc oxide (InGaZnO)-based material, an indium tin zinc oxide (InSnZnO)-based material, an indium aluminum zinc oxide (InAlZnO)-based material, a tin gallium zinc oxide (SnGaZnO)-based material, an aluminum gallium zinc oxide (AlGaZnO)-based material, a tin aluminum zinc oxide (SnAlZnO)-based material which are ternary metallic oxides, an indium zinc oxide (InZnO)-based material, a tin zinc oxide (SnZnO)-based material, an aluminum zinc oxide (AlZnO)-based material, a zinc magnesium oxide (ZnMgO)-based material, a tin magnesium oxide (SnMgO)-based material, an indium magnesium oxide (InMgO)-based material, an indium gallium oxide (InGaO)-based material, which are bimetallic oxides, an indium oxide (InO)-based material, a tin oxide (SnO)-based material, a zinc oxide (ZnO)-based material, and the like, but a composition ratio of individual elements is not limited.

The semiconductor layer 328 may include a source region and a drain region which include n-type or p-type impurities, and a channel between the source region and the drain region and a lightly doped region between the source region and the drain region, which is adjacent to the channel.

The semiconductor layer 328 may include an area doped with one impurity of boron (B), aluminum (Al), gallium (Ga), and indium (In). The semiconductor layer 328 may include an area heavily doped with one impurity of phosphorus (P), arsenic (As), and antimony (Sb).

A first insulating layer 314 is an insulating layer which is configured by a single layer or multiple layers of silicon oxide (SiOx) or silicon nitride (SiNx) and is disposed such that the current flowing in the semiconductor layer 328 does not flow to the gate electrode 322. The silicon oxide has ductility which is lower than that of metal, but is better than that of the silicon nitride and may be selectively formed by a signal layer or multiple layers depending on the characteristic.

When the polycrystalline silicon is applied to the semiconductor layer 328, an insulating layer disposed to be adjacent to the semiconductor layer 328 may form an inorganic layer having a high content of hydrogen particles. For example, when silicon nitride SiNx is disposed in a layer adjacent to the polycrystalline silicon semiconductor layer 328 and silicon oxide SiOx is disposed in a layer which is not adjacent thereto, hydrogen particles are diffused into the polycrystalline semiconductor layer 328 to be stabilized. Therefore, degradation of the characteristic of the thin film transistor 320 may be suppressed.

When the oxide semiconductor is applied to the semiconductor layer 328, an insulating layer disposed to be adjacent to the semiconductor layer 328 may form an inorganic layer having a low hydrogen content. For example, when silicon oxide SiOx is disposed in a layer adjacent to the oxide semiconductor layer 328 and silicon nitride SiNx is disposed in a layer which is not adjacent, diffusion of the hydrogen particles into the oxide semiconductor layer 328 is suppressed to suppress degradation of the characteristic of the thin film transistor 320.

The gate electrode 322 serves as a switch which turns on or turns off the thin film transistor 320 based on an electric signal transmitted from the outside through a gate line. The gate electrode may be configured by a single layer or multiple layers of copper (Cu), aluminum (Al), molybdenum (Mo), chrome (Cr), gold (Au), titanium (Ti), nickel (Ni), and neodymium (Nd) which are conductive metals or an alloy thereof, but is not limited thereto.

The source electrode 324 and the drain electrode 326 are connected to the data line and transmit the electric signal, which is transmitted from the outside, from the thin film transistor 320 to the light emitting diode 330. The source electrode 324 and the drain electrode 326 may be configured by a single layer or multiple layers of a metallic material such as copper (Cu), aluminum (Al), molybdenum (Mo), chrome (Cr), gold (Au), titanium (Ti), nickel (Ni), and neodymium (Nd) which are conductive metals or an alloy thereof, but are not limited thereto.

In order to insulate the gate electrode 322 from the source electrode 324 and the drain electrode 326, a second insulating layer 316 configured of silicon oxide (SiOx) or silicon nitride (SiNx) may be disposed between the gate electrode 322 and the source electrode 324 and the drain electrode 326.

A passivation layer which is configured by an inorganic insulating layer such as silicon oxide SiOx or silicon nitride SiNx may be further disposed on the thin film transistor 320. The passivation layer may serve to suppress unnecessary electrical connection between components above and below the passivation layer and suppress contamination or damage from the outside. However, the passivation layer may be omitted in accordance with a configuration and a characteristic of the thin film transistor 320 and the light emitting diode 330.

The thin film transistor 320 may be classified into an inverted staggered structure and a coplanar structure depending on the position of the components which configure the thin film transistor 320. In an inverted staggered thin film transistor, a gate electrode is disposed to be opposite to the source electrode and the drain electrode with respect to the semiconductor layer. In a coplanar thin film transistor 320, the gate electrode 322 is located on the same side as the source electrode 324 and the drain electrode 326 with respect to the semiconductor layer 328.

Even though in FIG. 3, the coplanar thin film transistor 320 has been illustrated, the organic light emitting display device 100 may include an inverted staggered thin film transistor.

For the convenience of description, only a driving thin film transistor among various thin film transistors which may be included in the organic light emitting display device 100 is illustrated. However, a switching thin film transistor and a capacitor may also be included in the organic light emitting display device 100. When a signal is applied from the gate line, the switching thin film transistor transmits a signal from the data line to the gate electrode of the driving thin film transistor. The driving thin film transistor transmits a current, which is transmitted through a power line by the signal transmitted from the switching thin film transistor, to the anode and controls the emission by the current which is transmitted to the anode.

The planarization layer 318 is disposed on the thin film transistor 320 to protect the thin film transistor 320, relieve a step generated due to the thin film transistor 320, and reduce a parasitic capacitance generated between the thin film transistor 320 and the gate line and the data line, and the light emitting diodes 330.

A plurality of planarization layers 318 may be formed according to a structure and a characteristic of the organic light emitting display device 100. The planarization layer may be formed of one or more materials of acrylic resin, epoxy resin, phenolic resin, polyamides resin, polyimides resin, unsaturated polyesters resin, polyphenylene resin, polyphenylenesulfides resin, and benzocyclobutene, but are not limited thereto.

The light emitting diode 330 disposed on the planarization layer 318 includes an anode 332, a light emitting unit or layer 334, and a cathode 336.

The anode 332 disposed on the planarization layer 318 may be configured by indium tin oxide (ITO) and indium zinc oxide (IZO) which are transparent conductive materials, but is not limited thereto. The anode 332 is disposed on the planarization layer 318 so that for the convenience of description, it is described that the anode is disposed on the substrate 310.

When the organic light emitting display device 100 is a top emission type which emits light to an upper portion on which the cathode 336 is disposed, the organic light emitting display device 100 may further include a reflective layer to cause the emitted light to be reflected from the anode 332 and be more easily emitted to an upper direction where the cathode 336 is disposed.

For example, the anode 332 may have a double-layered structure in which a transparent conductive layer configured by a transparent conductive layer and a reflective layer are sequentially laminated or a triple-layered structure in which a transparent conductive layer, a reflective layer, and a transparent conductive layer are sequentially laminated. The reflective layer may be silver (Ag) or an alloy including silver.

A pixel which partitions an area in which light is actually emitted is defined by the bank layer 340 disposed on the anode 332 and the planarization layer 318. That is, the bank layer 340 is disposed on the planarization layer 318 to expose at least a center portion of a top surface of the anode. The anode 340 may include at least one opening to expose at least a center portion of the top surface of the anode. Further, the bank layer 340 is disposed on the planarization layer 318 so that for the convenience of description, it may be described that the bank layer is disposed on the substrate 310.

The bank layer 340 is formed by photolithography after forming photoresist. The photoresist refers to a photosensitive resin whose solubility to a developing solution is changed by the action of light and the photoresist is exposed and developed to obtain a specific pattern.

The photoresist may be classified into a positive photoresist and a negative photoresist. The positive photoresist is a photoresist whose solubility of the exposed portion in the developing solution is increased by the exposure. When the positive photoresist is developed, a pattern from which exposed portions are removed is obtained. The negative photoresist is a photoresist whose solubility of the exposed portion in the developing solution is significantly lowered by the exposure. When the negative photoresist is developed, a pattern from which non-exposed portions are removed is obtained.

In order to form the light emitting unit 334 of the organic light emitting display device 100, a fine metal mask (FMM) which is a deposition mask may be used. Further, in order to suppress the damage which may be generated due to the contact with a deposition mask disposed on the bank layer 340 and maintain a predetermined or selected distance between the bank layer 340 and the deposition mask, a spacer (not illustrated) is disposed on the bank layer 340.

The spacer (not illustrated) may be configured by the same material as the bank layer 340 to be formed by one process. In a folding area in which the flexible organic light emitting display device 100 is folded, the spacer (not illustrated) is formed on the bank layer 340 in an area adjacent to the light emitting diode 330 to suppress the peeling caused by the folding.

The light emitting unit 334 is disposed between the anode 332 and the cathode 336. The light emitting unit 334 serves to emit light and may include at least one layer of a hole injection layer (HIL), a hole transport layer (HTL), an emission layer, an electron transport layer (ETL), and an electron injection layer (EIL). Some components of the light emitting unit 334 may be omitted depending on the structure or the characteristic of the organic light emitting display device 100. Here, as the emission layer, an organic emission layer and an inorganic emission layer may also be applied.

The hole injection layer is disposed on the anode 332 to smoothly inject the holes. The hole injection layer may be formed of one or more of HAT-CN(dipyrazino[2,3-f:2',3'-h]quinoxaline-2,3,6,7,10.11-hexacarbonitrile), CuPc(phthalocyanine), and NPD(N,N'-bis(naphthalene-1-yl)-N,N'-bis(phenyl)-2,2'-dimethylbenzidine).

The hole transport layer is disposed on the hole injection layer to smoothly transmit holes to the emission layer. For example, the hole transport layer may be formed of one or more of NPD(N,N'-bis(naphthalene-1-yl)-N,N'-bis(phenyl)-2,2'-dimethylbenzidine), TPD(N,N'-bis-(3-methylphenyl)-N,N'-bis-(phenyl)-benzidine), s-TAD(2,2',7,7'-tetrakis(N,N-dimethylamino)-9,9-spirofluorene), and MTDATA(4,4',4"-Tris(N-3-methylphenyl-N-phenyl-amino)-triphenylamine).

The emission layer is disposed on the hole transport layer and includes a material which emits specific color light to emit specific color light. The light emitting material may be formed using a phosphor or a fluorescent material.

When the emission layer emits red light, an emitting peak wavelength may be in the range of 600 nm to 650 nm. The emission layer may include a host material including CBP(4,4'-bis(carbazol-9-yl)biphenyl) or mCP(1,3-bis(carbazol-9-yl)benzene) and may be formed of a phosphor including a dopant including one or more of PIQIr(acac)(bis(1-phenylisoquinoline)(acetylacetonate) iridium), PQIr(acac)(bis(1-phenylquinoline)(acetylacetonate) iridium), PQIr(tris(1-phenylquinoline) iridium), and PtOEP(octaethylporphyrin platinum). Alternatively, the emission layer may be formed of a fluorescent material including PBD : Eu(DBM)3(Phen) or perylene.

Here, a peak wavelength λ refers to a wavelength of maximum electroluminescence (EL). A wavelength at which emission layers configuring the light emitting unit emit unique light is referred to as photoluminescence (PL) and light emitted by the influence of the thickness or the optical characteristic of layers configuring the emission layers is referred to as emittance. In this case, electroluminescence (EL) refers to light which is finally emitted by the electroluminescent display device and may be represented by a product of photoluminescence (PL) and emittance.

When the emission layer emits green light, an emitting peak wavelength may be in the range of 520 nm to 540 nm. The emission layer may include a host material including CBP or mCP and may be formed of a phosphor including a dopant material including Ir(ppy)₃(tris(2-phenylpyridine)iridium) such as Ir complex. Further, the emission layer may be formed of a fluorescent material including Alq₃(tris(8-hydroxyquinolino)aluminum).

When the emission layer emits blue light, an emitting peak wavelength may be in the range of 440 nm to 480 nm. The emission layer may include a host material including CBP or mCP and may be formed of a phosphor including a dopant material including FIrPic(bis(3,5-difluoro-2-(2-pyridyl)phenyl-(2-carboxypyridyl)iridium). Alternatively, the emission layer may be formed of a fluorescent material including any one of spiro-DPVBi(4,4'-Bis(2,2-diphenyl-ethen-1-yl)biphenyl), DSA(1-4-di-[4-(N,N-di-phenyl)amino]styryl-benzene), PFO(polyfluorene)-based polymer, and PPV(polyphenylenevinylene)-based polymer.

The electron transport layer is disposed on the emission layer to smoothly move the electrons to the emission layer. For example, the electron transport layer may be formed of one or more of Liq(8-hydroxyquinolinolato-lithium), PBD(2-(4-biphenyl)-5-(4-tert-butylphenyl)-1,3,4-oxadiazole), TAZ(3-(4-biphenyl)4-phenyl-5-tert-butylphenyl-1,2,4-triazole), spiro-PBD, BCP(2,9-Dimethyl-4,7-diphenyl-1,10-phenanthroline), and Balq(bis(2-methyl-8-quinolinolate)-4-(phenylphenolato)aluminum).

The electron injection layer may be further disposed on the electron transport layer. The electron injection layer is an organic layer which smoothly injects the electrons from the cathode 336 and may be omitted depending on the structure and the characteristic of the organic light emitting display device 100. The electron injection layer may be a metal inorganic compound such as BaF2, LiF, NaCl, CsF, Li₂O, and BaO or one or more organic compounds of HAT-CN(dipyrazino[2,3-f:2',3'-h]quinoxaline-2,3,6,7,10.11-hexacarbonitrile), CuPc(phthalocyanine), and NPD(N,N'-bis(naphthalene-1-yl)-N,N'-bis(phenyl)-2,2'-dimethylbenzidine).

An electron blocking layer or a hole blocking layer which blocks the flow of holes or electrons is further disposed to be close to the emission layer. Therefore, a phenomenon that when the electrons are injected to the emission layer, the electrons move from the emission layer to pass through an adjacent hole transport layer or when the holes are injected to the emission layer, the holes move from the emission layer to pass through an adjacent electron transport layer is suppressed to improve luminous efficiency.

The cathode 336 is disposed on the light emitting unit 334 to supply electrons to the light emitting unit 334. Since the cathode 336 supplies electrons, the cathode 336 may be configured by a metal material which is a conductive material having a low work function such as magnesium (Mg) or silver-magnesium (Ag : Mg), but is not limited thereto.

When the organic light emitting display device 100 is a top emission type, the cathode 336 may be indium tin oxide (ITO), indium zinc oxide (IZO), indium tin zinc oxide (ITZO), zinc oxide (ZnO), and tin oxide (TiO)-based transparent conductive oxides.

An encapsulation unit or multilayer 350 is disposed on the light emitting diode 330 to suppress oxidation or damage of the thin film transistor 320 and the light emitting diode 330 which are components of the organic light emitting display device 100, due to moisture, oxygen, or impurities introduced from the outside.

The encapsulation unit 350 may be formed by laminating a plurality of encapsulation layers 352 and 356, a foreign material compensation layer 354, and a plurality of barrier films 358.

The first encapsulating layer 352 is disposed on entire upper surfaces of the thin film transistor 320 and the light emitting diode 330 and may be configured by one of silicon nitride (SiNx) or aluminum oxide (AlyOz) which is an inorganic material, but is not limited thereto. A second encapsulation layer 356 may be further disposed on the foreign material compensation layer 354 disposed on the first encapsulation layer 352 and the first encapsulation layer 352 may be formed by a process, such as atomic layer deposition (ALD), but is not limited thereto.

The first encapsulation layer 352 is bonded on a side surface of a second spacer 344 which has two reverse-tapered structures and fixes the light emitting diode 330 to suppress the peeling of the light emitting diode 330 disposed in the folding area in which the organic light emitting display device 100 is folded and improve the adhesiveness.

The foreign material compensation layer 354 is disposed on the first encapsulation layer 352 and may use silicon oxy carbon (SiOCz), acryl, or epoxy-based resin, but is not limited thereto. When a defect is caused by a crack generated by foreign materials or particles which may be generated during the process, the curve and the foreign materials are covered by the foreign material compensation layer 354 to be compensated.

A barrier film 358 is disposed on the encapsulation layers 352 and 356 and the foreign material compensation layer 354 to delay the permeation of the oxygen and moisture into the organic light emitting display device 100 from the outside. The barrier film 358 is configured as a film having translucency and both-sided adhesiveness and may be configured by any one insulating material of olefin-based, acrylic-based, and silicon-based insulating materials. Further, the barrier film which is configured by any one material of cycloefin polymer (COP), cycloolefin copolymer (COC), and polycarbonate (PC) may be further laminated, but is not limited thereto.

The organic light emitting display device 100 according to the exemplary embodiment of the present specification includes a flexible substrate, a folding area in which the flexible substrate of the display area is folded, a thin film transistor, a bank layer, a light emitting diode, at least one or more spacers, and an encapsulation unit. The flexible substrate includes a display area including a pixel and a non-display area at the outside of the display area. The thin film transistor is disposed on the display area and the bank layer is disposed on the thin film transistor and partitions the pixel. The light emitting diode is disposed to be adjacent to the bank layer and at least one or more spacers are disposed on the bank layer and have a reverse-tapered structure. The encapsulation unit is disposed on the light emitting diode, a first spacer, and a second spacer.

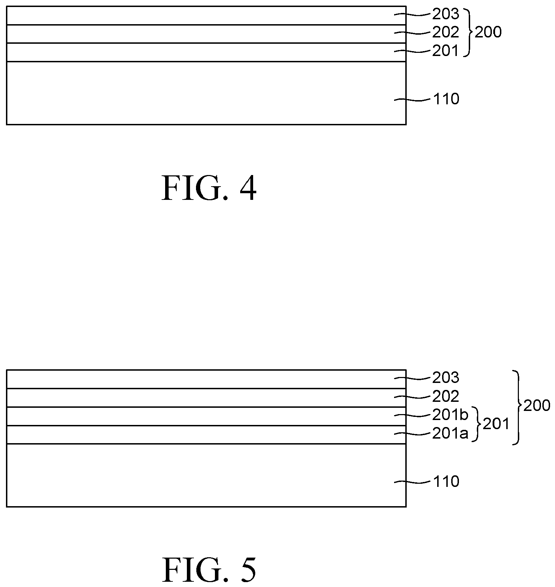

FIG. 4 is a schematic cross-sectional view illustrating an example of a display device including a reflective visibility adjusting film disposed on a display panel of FIG. 1.

For reference, among the descriptions of the components disclosed in FIG. 4, the same or repeated contents as those described above may be omitted.

Referring to FIG. 4, the display device according to the exemplary embodiment of the present specification includes a display panel 110 and a reflective visibility adjusting film 200 disposed on the display panel 110. At this time, the reflective visibility adjusting film 200 may include a first layer 201, a barrier film 202 on the first layer 201, and a second layer 203 on the barrier film 202.

At this time, the display panel may be a panel which has been described above with reference to FIGS. 1 and 2 and has a pixel of FIG. 3. The display panel 110 may be an organic light emitting display panel, but is not limited thereto.

The display panel 110 may have a reflectance for light having a reference wavelength which is equal to or lower than a first reflectance. For example, the display panel 110 may have a reflectance for light with a wavelength of 550 nm which is higher than 0% and 10% or lower. Further, the reflectance of the display panel in a first wavelength range may be smaller than a reflectance of the display panel 110 in a third wavelength range.

That is, the display panel 110 may have a reflectance which is equal to or lower than a first reflectance and have a 1-1-th reflectance at a first reference wavelength and a 1-2-th reflectance at a second reference wavelength. At this time, the 1-1-th reflectance may be higher than the 1-2-th reflectance.

For example, the first reference wavelength may be 650 nm or higher and 680 nm or lower and the second reference wavelength may be 420 nm or higher and 440 nm or lower. That is, the 1-1-th reflectance of the display panel 110 in the wavelength of 650 nm or higher and 680 nm or lower may be higher than the 1-2-th reflectance of the display panel 110 in the wavelength of 420 nm or higher and 440 nm or lower. As described above, the display panel 110 may reflect more light for a reddish wavelength. Accordingly, the display panel 110 in the present specification may be a panel having a reddish black appearance.

The first layer 201 may have a specific or selected transmittance range for light in a specific or selected wavelength range. The first layer 201 may have a first transmittance in a first wavelength range, a second transmittance in a second wavelength range which is different from the first wavelength range, and a third transmittance in a third wavelength range which is different from the first wavelength range and the second wavelength range.

For example, the first wavelength range may be a wavelength range corresponding to blue light, in a visible light wavelength range. The second wavelength range may be a wavelength range corresponding to green light, in a visible light wavelength range. A third wavelength range may be a wavelength range corresponding to red light, in a visible light wavelength range. For example, the first wavelength range may be 430 nm or higher and lower than 480 nm, the second wavelength range may be 480 nm or higher and lower than 630 nm, and the third wavelength range may be 630 nm or higher and lower than 780 nm.

The first layer 201 is a layer including a dye and also including a pressure sensitive adhesive (PSA) as well as the dye.

As an exemplary embodiment, Cases 1, 2 and 3 which are examples of the first layer 201 are as follows:
For example, the first wavelength range may be 430 nm or higher and lower than 480 nm, the second wavelength range may be 480 nm or higher and lower than 630 nm, and the third wavelength range may be 630 nm or higher and lower than 780 nm.

At this time, the first transmittance is 63% ± 2%, such as 63% ± 1%. The second transmittance is 58% ± 2%, such as 58% ± 1%. The third transmittance is 60% ± 2%, such as 60% ± 1% (hereinafter, Case 1).

In Case 1, a white color temperature (WCT) luminance of the display device is 100% or higher and 107% or lower and a correlated color temperature (CCT) of the display device may be 9000 K or higher and 11000 K or lower. Further, in an embodiment of Case 1, a white color temperature luminance of the display device may be 105.0% and a correlated color temperature of the display device may be 9965 K.

As another example, the first wavelength range is 430 nm or higher and lower than 480 nm, the second wavelength range is 480 nm or higher and lower than 630 nm, and the third wavelength range is 630 nm or higher and lower than 780 nm. At this time, the first transmittance may be 66% ± 2%, such as 66% ± 1%. The second transmittance may be 60% ± 2%, such as 60% ± 1%. The third transmittance may be 66% ± 1% (hereinafter, Case 2).

In Case 2, a white color temperature (WCT) luminance of the display device may be 100% or higher and 105% or lower and a correlated color temperature (CCT) of the display device may be 9000 K or higher and 11000 K or lower. Further, in an embodiment of Case 2, a white color temperature (WCT) luminance of the display device may be 104.7% and a correlated color temperature of the display device may be 10691 K.

As another example, the first wavelength range is 430 nm or higher and lower than 480 nm, the second wavelength range is 480 nm or higher and lower than 630 nm, and the third wavelength range is 630 nm or higher and lower than 780 nm. At this time, the first transmittance is 63% ± 2%, such as 63% ± 1%. The second transmittance is 60% ± 2%, such as 60% ± 1%. The third transmittance is 63% ± 2%, such as 63% ± 1% (hereinafter, Case 3).

In Case 3, a white color temperature (WCT) luminance of the display device is 100% or higher and 105% or lower and a correlated color temperature (CCT) of the display device may be 9000 K or higher and 11000 K or lower. Further, in an embodiment of Case 3, a white color temperature (WCT) luminance of the display device may be 103.7% and a correlated color temperature of the display device may be 9901 K.

The barrier film 202 is disposed on the first layer 201 and may include tri-acetyl cellulose (TAC) or acrylic resin as a support member. In some embodiments, the barrier film 202 may have a phase difference value of 100 nm or lower. At this time, the phase difference value Δnd may be a product of a thickness of the barrier film 202 and a refractive index anisotropy Δn of tri-acetyl cellulose (TAC) or acrylic resin which forms the barrier film 202.

The second layer 203 may be disposed on the barrier film 202. The second layer 203 may have a reflectance which is equal to or lower than the second reflectance at a reference wavelength. For example, the second layer 203 may have a reflectance which is 0.5% or lower at a wavelength of 550 nm. Further, the second layer 203 may have a minimum reflectance at a wavelength of 550 nm. That is, when the wavelength of incident light is 550 nm, the reflectance of the second layer 203 may be minimum. Further, the transmittance of the second layer 203 may be 99% or higher.

The second layer 203 may be a low reflective coating layer which is generally used. For example, the second layer 203 may be a single layer or a plurality of layers of two or more layers. The second layer 203 may include magnesium (Mg) or nitride which is known as a low reflective material. For reference, in Cases 1 to 3, the same second layer 203 may be used.

In Cases 1 to 3, the first layer 201 may include a first dye, a second dye, a third dye and a fourth dye.

The first to fourth dyes may be included in approximately 1% by weight of the total weight of the first layer 201 and the first layer 201 may further include 1% by weight of additive and 83% by weight of a basic adhesive.

In Cases 1 to 3, the first dye may be a dye having a maximum absorption wavelength of approximately 480 nm. For example, the first dye may be a pyrromethene cobalt complex dye.

In Cases 1 to 3, desirably, the second dye may be a dye having a maximum absorption wavelength of approximately 580 nm. For example, the second dye may be a tetraazaporphyrin copper complex dye.

In Cases 1 to 3, desirably, the third dye may be a dye having a maximum absorption wavelength of approximately 680 nm. For example, the third dye may be a phthalocyanine cobalt complex dye.

In Cases 1 to 3, desirably, the fourth dye may be a dye having a maximum absorption wavelength of approximately 780 nm. For example, the fourth dye may be a phthalocyanine copper complex dye.

As an exemplary embodiment, examples of Cases 1 to 3 are as follows.

In Case 1, the first layer 201 may include 0.35% to 0.39% by weight of a first dye with a maximum absorption wavelength in the range of 470 nm to 490 nm, 0.38% to 0.42% by weight of a second dye with a maximum absorption wavelength in the range of 570 nm to 590 nm, 0.38% to 0.42% by weight of a third dye with a maximum absorption wavelength in the range of 670 nm to 690 nm, and 0.38% to 0.42% by weight of a fourth dye with a maximum absorption wavelength in the range of 770 nm to 790 nm.

In Case 2, the first layer 201 may include 0.32% to 0.34% by weight of pyrromethene cobalt complex dye, 0.38% to 0.42% by weight of a tetraazaporphyrin copper complex dye, 0.32% to 0.36% by weight of a phthalocyanine cobalt complex dye, and 0.32% to 0.36% by weight of a phthalocyanine copper complex dye.

In Case 3, the first layer 201 may include 0.35% to 0.39% by weight of pyrromethene cobalt complex dye, 0.38% to 0.42% by weight of a tetraazaporphyrin copper complex dye, 0.38% to 0.42% by weight of a phthalocyanine cobalt complex dye, and 0.38% to 0.42% by weight of a phthalocyanine copper complex dye.

As an exemplary embodiment, examples of Cases 1 to 3 are as follows.

In Case 1, the first layer 201 may include 0.37% by weight of a first dye, 0.40% by weight of a second dye, 0.40% by weight of a third dye, and 0.40% by weight of a fourth dye.

In Case 2, the first layer 201 may include 0.34% by weight of a first dye, 0.40% by weight of a second dye, 0.34% by weight of a third dye, and 0.34% by weight of a fourth dye.

In Case 3, the first layer 201 may include 0.37% by weight of a first dye, 0.40% by weight of a second dye, 0.40% by weight of a third dye, and 0.40% by weight of a fourth dye.

Further, as an embodiment, examples of Cases 1 to 3 are as follows.

The first dye is a pyrromethene cobalt complex dye and may be or include a compound represented by Formula 1 below.

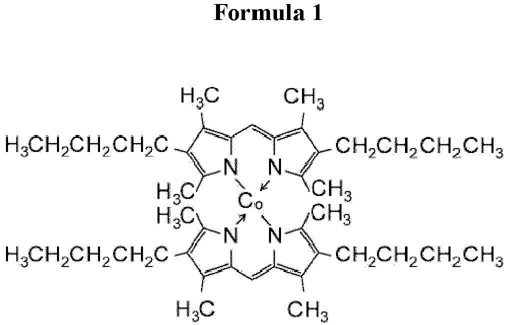

The second dye is a tetraazaporphyrin copper complex dye and may be or include a compound represented by Formula 2 below. The compound below is a product of Yamamoto Kasei, the product name is PD-311S, and the maximum absorption wavelength may be approximately 480 nm.

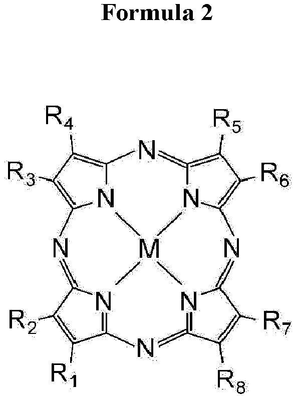

In Formula 2, each of R1, R2, R3, R4, R5, R6, R7 and R8 (or "R1 to R8") may be a hydrogen atom, a halogen atom, a nitro group, a cyano group, a hydroxyl group, an amino group, a carboxyl group, a sulfonate group, a straight chain branched or cyclic alkyl group having 1 to 20 carbon atoms, an alkoxy group having 1 to 20 carbon atoms, an aryloxy group having 6 to 20 carbon atoms, a monoalkylamino group having 1 to 20 carbon atoms, a dialkylamino group having 2 to 20 carbon atoms, a dialkylamino group having 7 to 20 carbon atoms, an aralkyl group having 7 to 20 carbon atoms, an aryl group having 6 to 20 carbon atoms, a heteroaryl group, an alkylthio group having 6 to 20 carbon atoms, and an arylthio group having 6 to 20 carbon atoms. Alternatively, in Formula 2, R1 to R8 are rings other than aromatic rings to which the atoms or the groups are coupled through a linkage, respectively and M represents two hydrogen atoms, a divalent metallic atom, divalent monosubstituted metallic atom, tetravalent disubstituted metallic atom, or an oxy metallic atom.

The third dye is a phthalocyanine cobalt complex dye and may be or include a compound represented by Formula 3. The compound below is a product of Yamada Chemical Co., Ltd., the product name is FDR-002, and the maximum absorption wavelength may be approximately 680 nm.

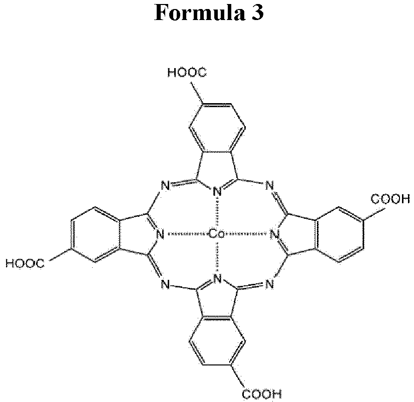

The fourth dye is a phthalocyanine copper complex dye and may be or include a compound represented by Formula 4 below. The compound below is a product of Yamada Chemical Co., Ltd., the product name is FDN-002, and the maximum absorption wavelength may be approximately 780 nm.

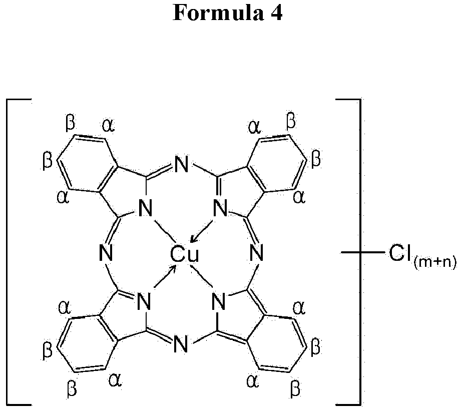

The phthalocyanine copper complex dye is a mixed crystal form of α and β forms, m represents the average number of chlorine substituents at the α-position, and n represents the average number of chlorine substituents at the β-position.

FIG. 5 is a schematic cross-sectional view illustrating another example of a display device including a reflective visibility adjusting film disposed on a display panel of FIG. 1.

For reference, among the descriptions of the components disclosed in FIG. 4, description of the same or repeated contents as those described above may be omitted.

Referring to FIG. 5, the reflective visibility adjusting film 200 disposed on the display panel 110 may include a first layer 201 including a 1-1-th layer 201a and a 1-2-th layer 201b.

The 1-1-th layer 201a may be a layer including the above-described pressure sensitive adhesive (PSA). At this time, the 1-1-th layer 201a may not include the above-described first, second, third and fourth dyes (or "first to fourth dyes").

The 1-2-th layer 201b may be a hard coating layer. At this time, the 1-2-th layer 201b may include the above-described first to fourth dyes. Examples of colorants of Cases 1 to 3 described above may be included in the 1-2-th layer 201b.

The 1-2-th layer 201b has a light transmittance of 96% and may be a hard coating layer which is generally used. The hard coating layer is located above the 1-1-th layer 201a to protect the display panel and the 1-1-th layer 201a and suppresses the damage of the display panel and the 1-1-th layer 201a due to the external physical force. That is, the hard coating layer is formed at the outermost side of the display device to protect the display panel, the 1-1-th layer 201a, and the like.

The hard coating layer is formed as a single layer or formed with a multilayered structure of two or more layers. In the meantime, a material of the hard coating layer is not specifically limited and various materials used in the art to improve a surface hardness of a plastic film may be used without limitation. A thickness of the hard coating layer may be, for example, 5 µm to 100 µm, such as 6 µm to 50 µm, but is not limited thereto.

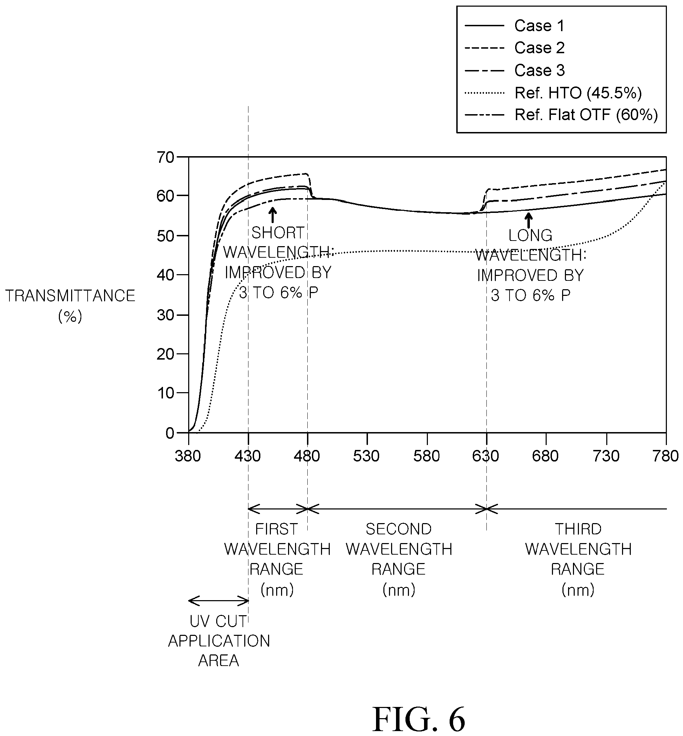

FIG. 6 is a graph obtained by measuring transmittance for wavelengths associated with Cases 1 to 3 of a first layer which configures a reflective visibility adjusting film used for a display device according to an exemplary embodiment of the present disclosure. Namely, the graph of FIG. 6 is obtained by measuring transmittance for wavelengths from 380 nm to 780 nm.

In Cases 1 to 3, the first layer may include first to fourth dyes at the above-described content ratios. In the case of a short wavelength, as compared with Comparative Embodiments of HTO and Flat OTF which were references, the transmittance was improved by 3% to 6% and, in the case of a long wavelength, the transmittance was also improved by 3% to 6%.

For reference, HTO refers to a display device which includes a low reflectivity film including a retardation layer, a barrier layer, and a polarizer layer and has an average transmittance in first, second and third wavelength ranges that is approximately 45.5%. Unlike Cases 1 to 3, the flat OTF refers to a low reflectivity film having a flat transmittance graph in the first, second and third wavelength ranges, and an average transmittance of approximately 60%.

Referring to FIG. 6, it is confirmed that in Cases 1 to 3, the transmittance is generally improved in the short wavelength and long wavelength visible light ranges as compared with the HTO (45.5%) and the flat OTF (60%) which are references.

Specifically, as compared with the HTO (45.5%) which is a reference, transmittance of Cases 1 to 3 is improved in the three wavelength ranges. That is, the first to fourth dyes described above are included in the first layer and it is confirmed that the transmittance in a specific wavelength range is improved.

In Cases 1 to 3, in a first wavelength range (430 nm to 480 nm) which is a shorter wavelength area than the flat OTF (60%) which is a reference, the transmittance is approximately 3 to 6% higher. In Cases 1 to 3, in a third wavelength range (630 nm to 780 nm) which is a longer wavelength area than the flat OTF (60%) which is a reference, the transmittance is approximately 3 to 6% higher. By doing this, in Cases 1 to 3, the transmittance is improved more than the flat OTF (60%) which is a reference in the first to third wavelength ranges.

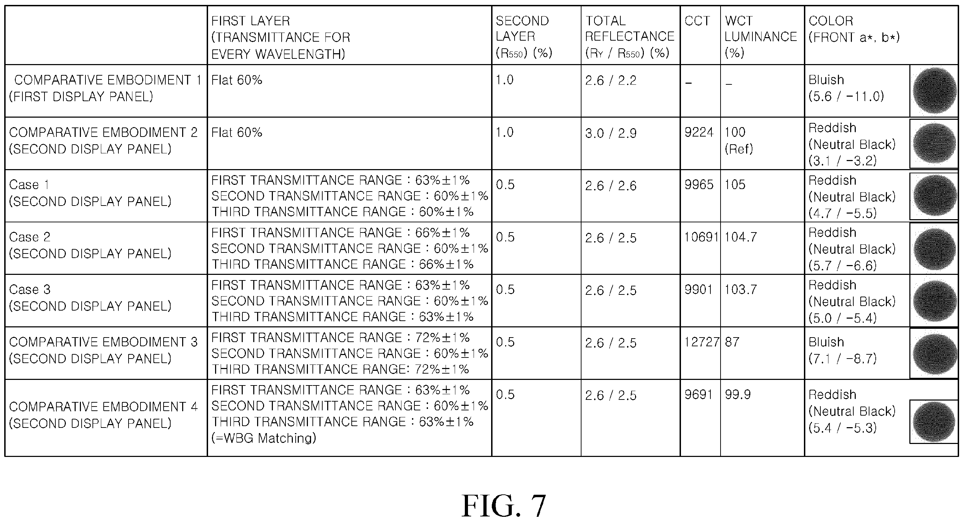

FIG. 7 is a table illustrating an optical characteristic of a reflective visibility adjusting film including a first layer of the above-described Cases 1 to 3. Referring to FIG. 7, Comparative Embodiment 1 has a structure in which a low reflectivity film including a first layer having a transmittance of Flat 60% and a second layer having reflectivity at 550 nm (R₅₅₀) of 1.0% is disposed on the first display panel, which has a bluish external light reflective appearance. The first display panel is a Comparative Embodiment, rather than the display panel used for the display device of the present disclosure, and a reflectance in a wavelength range of 650 nm to 680 nm is lower than a reflectance in a wavelength range of 420 nm to 440 nm. By doing this, even though the first layer having a transmittance of Flat 60% of the related art is used on the first display panel, the bluish external reflective appearance is obtained. A basic reflectance of the first display panel is low so that it seems that the total reflectance is also relatively low.

Comparative Embodiment 2 has a structure in which a low reflectivity film including a first layer having a transmittance of Flat 60% and a second layer having R₅₅₀ of 1.0% is disposed on the second display panel, which has a reddish external light reflective appearance. The second display panel is the display panel used for the display device of the present disclosure, and a reflectance in the wavelength of 650 nm to 680 nm is higher than a reflectance in a wavelength of 420 nm to 440 nm. When a first layer having a transmittance of Flat 60% of the related art is used on the second display panel having a reddish external light reflective appearance, the appearance may be closer to the neutral black than Comparative Embodiment 1. However, it is confirmed that the a*, b* color coordinate values are far away from (5, -5), and the reddish appearance still occurs.

In Case 1, as compared with Comparative Embodiment 2, a reflective visibility adjusting film including a first layer having a predetermined or selected transmittance as illustrated in the table of FIG. 7 and a second layer having R₅₅₀ of 0.5% is disposed on the second display panel having the reddish external light reflective appearance. At this time, it is confirmed that the reflectance (R_{γ}/R₅₅₀) is 2.6/2.6, which is more excellent than Comparative Embodiment 2 and is similar to Comparative Embodiment 1. In the meantime, as compared with Comparative Embodiment 2, in Case 1, the a*, b* color coordinate values are closer to (5, -5) so that it is confirmed that the appearance is closer to the neutral black than Comparative Embodiment 2.

For reference, in the present specification, the black appearance may refer to how similar the color temperature measured in a state in which a perfect black image is displayed on the display device is to the perfect black.

It is confirmed that WCT luminance of Case 1 is also higher than that of Comparative Embodiment 2 which is a reference.

For reference, the reflectance R_{γ} may be an average reflectance of the entire wavelength range used for the experiment and the reflectance R₅₅₀ may be a reflectance for light of a wavelength of 550 nm among wavelengths used for the experiment.

In Case 2, a reflective visibility adjusting film including a first layer having a predetermined or selected transmittance as illustrated in the table of FIG. 7 and a second layer having R₅₅₀ of 0.5% is disposed on the second display panel having the reddish external light reflective appearance. At this time, it is confirmed that the reflectance (R_{γ}/R₅₅₀) is 2.6/2.5, which is similar to Comparative Embodiment 2 and Comparative Embodiment 1. In the meantime, as compared with Comparative Embodiment 2, in Case 2, the a*, b* color coordinate values are closer to (5, -5) so that it is confirmed that the appearance is closer to the neutral black than Comparative Embodiment 2. Further, it is confirmed that WCT luminance of Case 2 is also higher than that of Comparative Embodiment 2 which is a reference.

In Case 3, a reflective visibility adjusting film including a first layer having a predetermined or selected transmittance as illustrated in the table of FIG. 7 and a second layer having R₅₅₀ of 0.5% is disposed on the second display panel having the reddish external reflective appearance. At this time, it is confirmed that the reflectance (R_{γ}/R₅₅₀) is 2.6/2.5, which is more excellent than Comparative Embodiment 2 and similar to Comparative Embodiment 1. In the meantime, as compared with Comparative Embodiment 2, it is confirmed that in Case 3, a*, b* color coordinate values are (5.0, -5.4) which are closest to the neural black of the various embodiments.

It is confirmed that WCT luminance of Case 3 is also higher than that of Comparative Embodiment 2 which is a reference.

In Comparative Embodiment 3, a film including a first layer having a predetermined or selected transmittance as illustrated in Table of FIG. 7 and a second layer having R₅₅₀ of 0.5% is disposed on the second display panel having the reddish external light reflective appearance. In Comparative Embodiment 3, as compared with Cases 1 to 3, the first layer has a high transmittance in the first wavelength range which is 430 nm or higher and lower than 480 nm. At this time, it is confirmed that the reflectance (R_{γ}/R₅₅₀) is 2.6/2.5, which is more excellent than Comparative Embodiment 2 and is similar to Comparative Embodiment 1. However, it is confirmed that the CCT is excessively higher than that in Cases 1 to 3 and a* and b* color coordinate values are (7.1, -8.7), which corresponds to a bluish black appearance. It is confirmed that WCT luminance of Comparative Embodiment 3 is lower than that of Comparative Embodiment 2 which is a reference.

In FIG. 7, in the color coordinates, a* is a coordinate value with respect to a red-green axis and b* is a coordinate value with respect to a yellow-blue axis. An origin in which a* = 0 and b* = 0 means that a reflective chroma is neutral black. At the origin, the larger the positive (+) value of the absolute value of a*, the stronger the red tendency, and the larger the negative (-) value of the absolute value of a*, the stronger the green tendency. Further, at the origin (O), as b* goes in the positive (+) direction, the yellow tendency becomes stronger and as b* goes in the negative (-) direction, the blue tendency becomes stronger. In other words, as a* coordinate value has a positive (+) value with a large absolute value and b* coordinate value has a negative (-) value or a positive (+) value with a small absolute value, the display device to measure a color may have a reddish black appearance. Further, when a* coordinate value has a positive (+) value and b* coordinate value has a negative (-) value, even though the absolute values of the a* coordinate value and the b* coordinate value are similar, it may have a neutral black.

The b* coordinate value of Comparative Embodiments 1 and 3 has a negative (-) value with a largest absolute value so that the display device has a bluish black appearance.

In contrast, in Comparative Embodiment 2, and Cases 1 to 3, the a* coordinate value has a positive (+) value and the b* coordinate value has a negative (-) value having a relatively small absolute value. Accordingly, in Comparative Embodiments 2 and 4 and Cases 1 to 3, the display device has a reddish black appearance.

Specifically, as the a* and b* coordinate values of the display device to measure the color are closer to (5, -5), it is analyzed that the display device has a more desirable neural black appearance. Accordingly, Cases 1 to 3 have a more neutral black than Comparative Embodiment 1. In the meantime, Cases 1 to 3 have a lower reflectance and improved WCT luminance than Comparative Embodiment 2, so that finally, it is confirmed that Cases 1 to 3 have the most excellent optical characteristic of the depicted embodiments.

As described above, Cases 1 to 3 have advantages in that the reflectance (lower reflectance) is better than that of Comparative Embodiments 1, 2, 3 and 4, the black appearance is closer to a neutral black, and the WCT luminance is high.

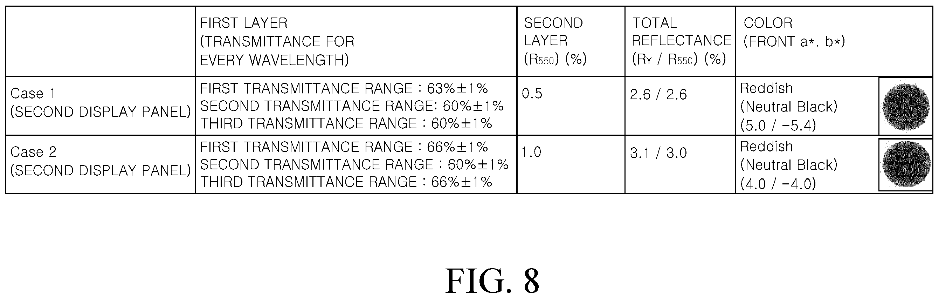

In other words, when a reflective visibility adjusting film including a first layer and a second layer (and a barrier layer between the first layer and the second layer) is laminated on a second display panel which basically reflects reddish light, like Cases 1 to 3, a display device which has a black appearance close to neutral black and has a high luminous efficiency may be manufactured. FIG. 8 is a table illustrating an optical characteristic of Case 3 according to a reflectance of a second layer.

Referring to FIG. 8, when R₅₅₀ (a reflectance in a wavelength of 550 nm) which is a reflectance of the second layer is 0.5% and 1.0%, an optical characteristic is disclosed. In the same condition, when only R₅₅₀ of the second layer is changed, it is confirmed that the total reflectance is changed. It is confirmed that the total reflectance when R₅₅₀ is 0.5% is lower than the total reflectance when R₅₅₀ is 1.0%. That is, the reflectance characteristic when R₅₅₀ is 0.5% is more excellent than the total reflectance characteristic when R₅₅₀ is 1.0%.

Further, it is confirmed that a color when R₅₅₀ of the second layer is 0.5% has a black appearance closer to a neutral black than a color when R₅₅₀ of the second layer is 1.0%.

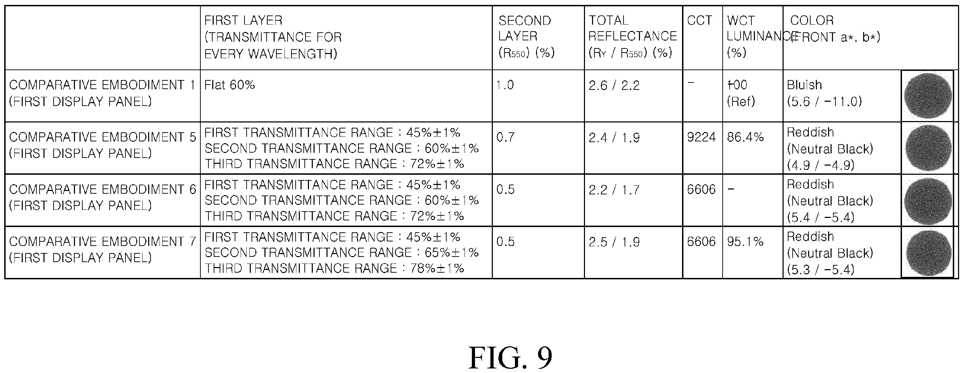

FIG. 9 is a table illustrating an optical characteristic of Comparative Embodiments 5, 6 and 7 which are additional comparative examples and a Comparative Embodiment of a HTO structure.

Referring to FIG. 9, it is confirmed that in the HTO structure, the color is between the reddish black appearance and the bluish black appearance.

Comparative Embodiments 5 to 7 may be a display device which uses a first layer having a transmittance different from that of Cases 1 to 3 described above. First to third transmittance ranges of Comparative Embodiments 5 to 7 are different from those of Cases 1 to 3. It is confirmed that the WCT luminance of Comparative Embodiments 5 and 7 is lower than Comparative Embodiment 1 which is a reference. It is confirmed that CCT of Comparative Embodiments 6 and 7 are much lower than 9000.

When optical characteristics of the exemplary embodiments are compared with reference to FIGS. 7 to 9, it is confirmed that the optical characteristics of Cases 1 to 3 which are main exemplary embodiments of the present specification are more excellent than the other Comparative Embodiments.

The exemplary embodiments of the present disclosure can also be described as follows:
According to an aspect of the present disclosure, there is provided a display device. The display device comprises a display panel in which a 1-1-th reflectance at a wavelength of 650 nm to 680 nm is larger than a 1-2-th reflectance at a wavelength of 420 nm to 440 nm; a first layer which is disposed on the display panel and has a first transmittance in a first wavelength range, a second transmittance in a second wavelength range different from the first wavelength range, and a third transmittance in a third wavelength range different from the first wavelength range and the second wavelength range; a barrier film disposed on the first layer; and a second layer disposed on the barrier film.

The first wavelength range may be 430 nm or higher and lower than 480 nm, the second wavelength range may be 480 nm or higher and lower than 630 nm, and the third wavelength range is 630 nm or higher and lower than 780 nm, and the first transmittance may bw higher than the second transmittance.

The first transmittance may be 63% ± 2%, the second transmittance may be 58% ± 2%, and the third transmittance may be 60% ± 2%.

The first transmittance may be 66% ± 2%, the second transmittance may be 60% ± 2%, and the third transmittance may be 66% ± 2%.

The first transmittance may be 63% ± 2%, the second transmittance may be 60% ± 2%, and the third transmittance may be 63% ± 2%.

A reflectance of the display panel at a wavelength of 550 nm may be 10% or lower.

A reflectance of the second layer at a wavelength of 550 nm may be 0.5% or lower at a wavelength of 550 nm.

A reflectance of the second layer may have a minimum value in a wavelength range of incident light of 540 nm to 560 nm.

A transmittance of the second layer may be 99% or higher.

The barrier film may include tri-acetyl cellulose (TAC) or acrylic resin.

The barrier film may have a phase difference value of 100 nm or lower.

The first layer may include a first dye having a maximum absorption wavelength in a range of 470 nm to 490 nm, a second dye having a maximum absorption wavelength in a range of 570 nm to 590 nm, a third dye having a maximum absorption wavelength in a range of 670 nm to 690 nm, and a fourth dye having a maximum absorption wavelength in a range of 770 nm to 790 nm.

The first layer may include 0.35 to 0.39% by weight of the first dye, 0.38 to 0.42% by weight of the second dye, 0.38 to 0.42% by weight of the third dye, and 0.38 to 0.42% by weight of the fourth dye.

The first layer may include 0.32 to 0.34% by weight of the first dye, 0.38 to 0.42% by weight of the second dye, 0.32 to 0.36% by weight of the third dye, and 0.32 to 0.36% by weight of the fourth dye.

The first layer may include 0.35 to 0.39% by weight of the first dye, 0.38 to 0.42% by weight of the second dye, 0.38 to 0.42% by weight of the third dye, and 0.38 to 0.42% by weight of the fourth dye.

The first dye may be a pyrromethene cobalt complex dye and may be configured by a compound represented by Formula 1 below.

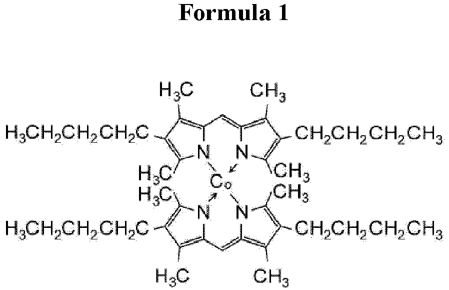

The second dye may be a tetraazaporphyrin copper complex dye and may be configured by a compound represented by Formula 2 below.

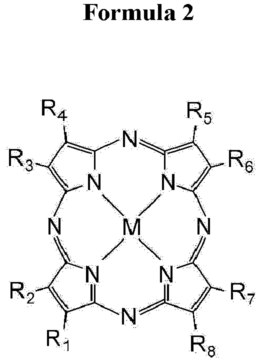

In Formula 2, R1 to R8 are each a hydrogen atom, a halogen atom, a nitro group, a cyano group, a hydroxyl group, an amino group, a carboxyl group, a sulfonate group, a straight chain branched or cyclic alkyl group having 1 to 20 carbon atoms, an alkoxy group having 1 to 20 carbon atoms, an aryloxy group having 6 to 20 carbon atoms, a monoalkylamino group having 1 to 20 carbon atoms, a dialkylamino group having 2 to 20 carbon atoms, a dialkylamino group having 7 to 20 carbon atoms, an aralkyl group having 7 to 20 carbon atoms, an aryl group having 6 to 20 carbon atoms, a heteroaryl group, an alkylthio group having 6 to 20 carbon atoms, and an arylthio group having 6 to 20 carbon atoms. Alternatively, in Formula 2, R1 to R8 are rings other than aromatic rings to which the atoms or the groups are coupled through a linkage, respectively and M represents two hydrogen atoms, a divalent metallic atom, divalent monosubstituted metallic atom, tetravalent disubstituted metallic atom, or an oxy metallic atom.

The third dye may be a phthalocyanine cobalt complex dye and may be configured by a compound represented by Formula 3 below.

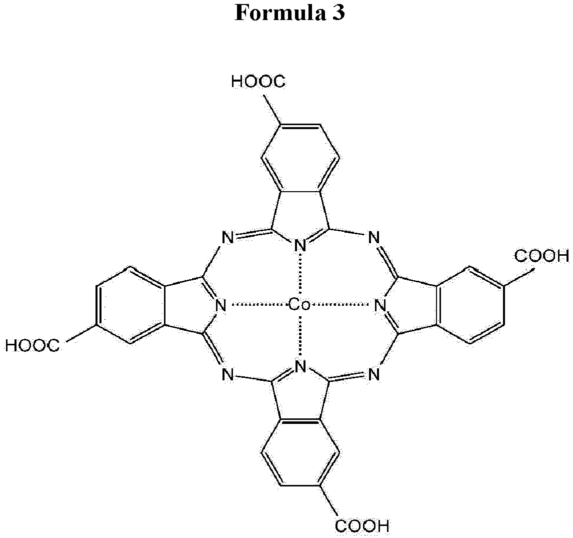

The fourth dye may be a phthalocyanine copper complex dye and may be configured by a compound represented by Formula 4 below.

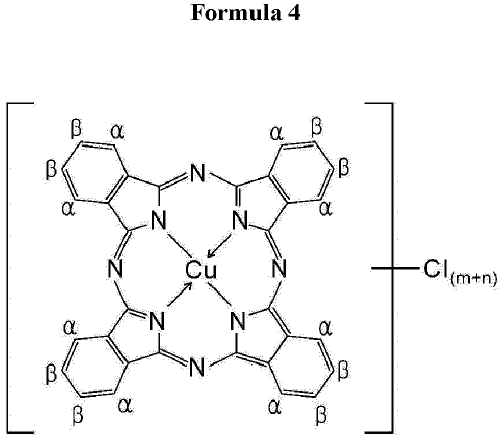

The phthalocyanine copper complex dye is a mixed crystal form of α and β forms, m represents the average number of chlorine substituents at an α -position, and n represents the average number of chlorine substituents at a β-position.

The first layer may further include a pressure sensitive adhesive (PSA).

The first layer may include a 1-1-th layer formed of a pressure sensitive adhesive; and a 1-2-th layer including the first dye, the second dye, the third dye, the fourth dye, and a hard coating material.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure.

The various embodiments described above can be combined to provide further embodiments. All of the U.S. patents, U.S. patent application publications, U.S. patent applications, foreign patents, foreign patent applications and non-patent publications referred to in this specification are incorporated herein by reference, in their entirety. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims. Accordingly, the claims are not limited by the disclosure.

Also disclosed are the following numbered clauses:
1. A display device, comprising:
   a display panel having first reflectance in a range of 650 nanometers (nm) to 680 nm that exceeds a second reflectance in a range of 420 nm to 440 nm; and
   a reflective visibility adjusting film on the display panel, the reflective visibility adjusting film including:
      a first layer having a first transmittance in a first wavelength range, a second transmittance in a second wavelength range and a third transmittance in a third wavelength range, the first, second and third wavelength ranges being different from each other; and
      a second layer disposed on the first layer, the second layer having reflectance at a wavelength of 550 nm that does not exceed 1%.
2. The display device of clause 1, wherein the reflectance does not exceed 0.5%.
3. A display device, comprising:
   a display panel having a reddish external light reflective appearance;
   a first layer disposed on the display panel, the first layer including:
      a first dye having a maximum absorption wavelength of approximately 480 nanometers (nm);
      a second dye having a maximum absorption wavelength of approximately 580 nm;
      a third dye having a maximum absorption wavelength of approximately 680 nm; and
      a fourth dye having a maximum absorption wavelength of approximately 780 nm, wherein the first, second, third and fourth dyes are included in the first layer at approximately 1% by weight of total weight of the first layer; and
      a second layer disposed on the first layer.
4. The display device of clause 3, wherein a reflectance of the second layer has a minimum value in a wavelength range of incident light of 540 nm to 560 nm.

## Claims

1. A display device, comprising:
a display panel in which a 1-1-th reflectance at a wavelength in a range of 650 nm to 680 nm is larger than a 1-2-th reflectance at a wavelength in a range of 420 nm to 440 nm;
a first layer which is disposed on the display panel and has a first transmittance in a first wavelength range, a second transmittance in a second wavelength range different from the first wavelength range, and a third transmittance in a third wavelength range different from the first wavelength range and the second wavelength range;
a barrier film disposed on the first layer; and
a second layer disposed on the barrier film.

2. The display device according to claim 1, wherein the first wavelength range is 430 nm or higher and lower than 480 nm, the second wavelength range is 480 nm or higher and lower than 630 nm, and the third wavelength range is 630 nm or higher and lower than 780 nm, and the first transmittance is higher than the second transmittance.

3. The display device according to claim 2, wherein:
the first transmittance is 63% ± 2%, the second transmittance is 58% ± 2% and the third transmittance is 60% ± 2%;
the first transmittance is 66% ± 2%, the second transmittance is 60% ± 2% and the third transmittance is 66% ± 2%; or
the first transmittance is 63% ± 2%, the second transmittance is 60% ± 2% and the third transmittance is 63% ± 2%.

4. The display device according to claim 2 or 3, wherein a reflectance of the display panel at a wavelength of 550 nm is 10% or lower.

5. The display device according to claim 4, wherein a reflectance of the second layer at a wavelength of 550 nm is 0.5% or lower, and optionally wherein a reflectance of the second layer has a minimum value in a wavelength range of incident light of 540 nm to 560 nm, and further optionally wherein a transmittance of the second layer is 99% or higher.

6. The display device according to any preceding claim, wherein the barrier film includes tri-acetyl cellulose (TAC) or acrylic resin, and optionally wherein the barrier film has a phase difference value of 100 nm or lower.

7. The display device according to any of claims 2 to 6, wherein the first layer includes a first dye having a maximum absorption wavelength in a range of 470 nm to 490 nm, a second dye having a maximum absorption wavelength in a range of 570 nm to 590 nm, a third dye having a maximum absorption wavelength in a range of 670 nm to 690 nm and a fourth dye having a maximum absorption wavelength in a range of 770 nm to 790 nm.

8. The display device according to claim 7, wherein the first layer includes 0.35% to 0.39% by weight of the first dye, 0.38% to 0.42% by weight of the second dye, 0.38% to 0.42% by weight of the third dye and 0.38% to 0.42% by weight of the fourth dye, or wherein the first layer includes 0.32% to 0.34% by weight of the first dye, 0.38% to 0.42% by weight of the second dye, 0.32% to 0.36% by weight of the third dye and 0.32% to 0.36% by weight of the fourth dye.

9. The display device according to claim 7 or 8, wherein the first dye is a pyrromethene cobalt complex dye and includes a compound represented by Formula 1:

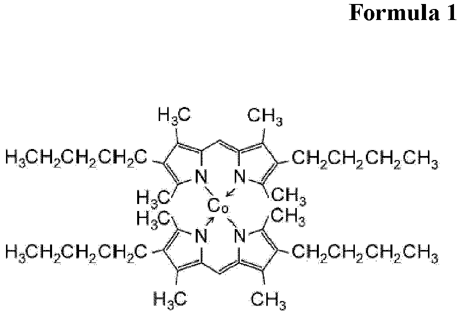

10. The display device according to any of claims 7 to 9, wherein the second dye is a tetraazaporphyrin copper complex dye and includes a compound represented by Formula 2: 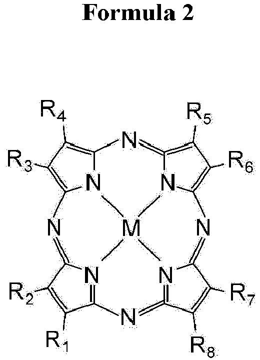
wherein each of R1, R2, R3, R4, R5, R6, R7 and R8 represents a hydrogen atom, a halogen atom, a nitro group, a cyano group, a hydroxyl group, an amino group, a carboxyl group, a sulfonate group, a straight chain branched or cyclic alkyl group having 1 to 20 carbon atoms, an alkoxy group having 1 to 20 carbon atoms, an aryloxy group having 6 to 20 carbon atoms, a monoalkylamino group having 1 to 20 carbon atoms, a dialkylamino group having 2 to 20 carbon atoms, a dialkylamino group having 7 to 20 carbon atoms, an aralkyl group having 7 to 20 carbon atoms, an aryl group having 6 to 20 carbon atoms, a heteroaryl group, an alkylthio group having 6 to 20 carbon atoms, and an arylthio group having 6 to 20 carbon atoms; or
wherein R1, R2, R3, R4, R5, R6, R7 and R8 represent rings other than aromatic rings to which the atoms or the groups are coupled through a linkage, respectively, and M represents two hydrogen atoms, a divalent metallic atom, divalent monosubstituted metallic atom, tetravalent disubstituted metallic atom, or an oxy metallic atom.

11. The display device according to any of claims 7 to 10, wherein the third dye is a phthalocyanine cobalt complex dye and includes a compound represented by Formula 3:

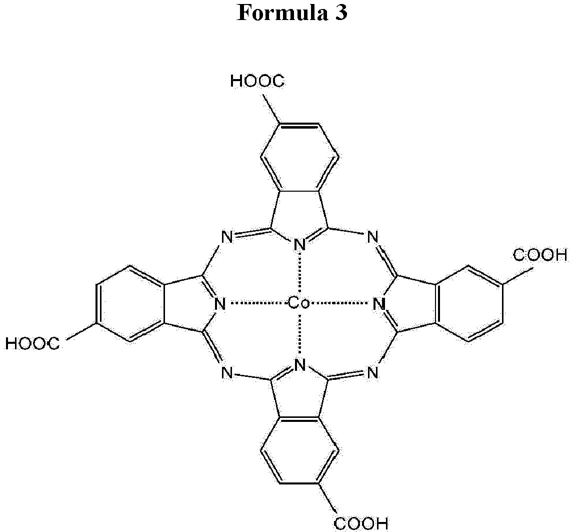

12. The display device according to any of claims 7 to 11, wherein the fourth dye is a phthalocyanine copper complex dye and includes a compound represented by Formula 4: 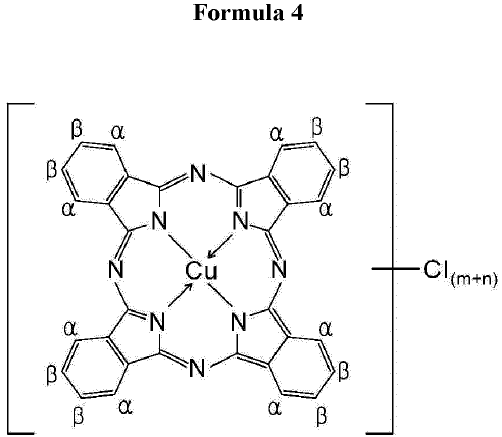 wherein the phthalocyanine copper complex dye is a mixed crystal form of σ and δ forms, m represents an average number of chlorine substituents at an α-position, and n represents an average number of chlorine substituents at a β-position.

13. The display device according to any of claims 7 to 12, wherein the first layer further includes a pressure sensitive adhesive (PSA), and/or wherein the first layer includes:
a 1-1-th layer including a pressure sensitive adhesive; and
a 1-2-th layer including the first dye, the second dye, the third dye, the fourth dye and a hard coating material.

14. A display device, comprising:
a display panel having first reflectance in a range of 650 nm to 680 nm that exceeds a second reflectance in a range of 420 nm to 440 nm; and
a reflective visibility adjusting film on the display panel, the reflective visibility adjusting film including:
a first layer having a first transmittance in a first wavelength range, a second transmittance in a second wavelength range and a third transmittance in a third wavelength range, the first, second and third wavelength ranges being different from each other; and
a second layer disposed on the first layer, the second layer having reflectance at a wavelength of 550 nm that does not exceed 1%.

15. A display device, comprising:
a display panel having a reddish external light reflective appearance;
a first layer disposed on the display panel, the first layer including:
a first dye having a maximum absorption wavelength of approximately 480 nm;
a second dye having a maximum absorption wavelength of approximately 580 nm;
a third dye having a maximum absorption wavelength of approximately 680 nm; and
a fourth dye having a maximum absorption wavelength of approximately 780 nm, wherein the first, second, third and fourth dyes are included in the first layer at approximately 1% by weight of total weight of the first layer; and
a second layer disposed on the first layer.
